# FASCICULE DE BREVET EUROPEEN

(11) **EP 4 100 627 B1**
(45) Date de publication et mention de la délivrance du brevet: **17.12.2025**
(21) Numéro de dépôt: 21707338.6
(22) Date de dépôt: 02.02.2021
(51) Int. Cl.: F01D 5/28, C22C 19/05, C23C 4/08, C30B 29/52, C23C 28/00

(54) **PIECE DE TURBOMACHINE EN SUPERALLIAGE A TENEUR EN HAFNIUM OPTIMISEE**
TURBOMASCHINENTEIL AUS SUPERLEGIERUNG MIT OPTIMIERTEM HAFNIUMGEHALT
PART OF A TURBOMACHINE MADE OF SUPERALLOY WITH OPTIMIZED HAFNIUM CONTENT

(30) Priorité: 06.02.2020 FR 2001166
(43) Date de publication de la demande: 14.12.2022
(73) Titulaire: SAFRAN AIRCRAFT ENGINES, 75015 Paris (FR); SAFRAN, 75015 Paris (FR); Centre national de la recherche scientifique, 75016 Paris (FR); Universite De La Rochelle, 17000 La Rochelle (FR)
(72) Inventeur: DELAUTRE, Joel, 77550 MOISSY-CRAMAYEL (FR); AUDIC, Christophe, Philippe, 77550 MOISSY-CRAMAYEL (FR); HAMADI, Sarah, 77550 MOISSY-CRAMAYEL (FR); JAQUET, Virginie, 77550 MOISSY-CRAMAYEL (FR); PEDRAZA DIAZ, Fernando, 17000 LA ROCHELLE (FR); PASQUET, Annie, 77550 MOISSY-CRAMAYEL (FR)
(74) Mandataire: Cabinet Beau de Loménie
(86) Numéro de dépôt international: PCT/FR2021/050187
(87) Numéro de publication internationale: WO 2021/156564

(56) Documents cités:
- EP-A1- 1 652 964
- EP-A1- 2 963 135
- US-A1- 2015 377 037

## Description

### Domaine Technique

La présente invention concerne le domaine des superalliages à base nickel et plus précisément les superalliages utilisés dans le domaine aéronautique.

### Technique antérieure

Les superalliages à base nickel sont connus pour avoir d'une part une résistance mécanique élevée même à haute température, et d'autre part une bonne résistance à l'oxydation. Pour ces deux propriétés, ils représentent un matériau de choix pour les pièces de turbomachines utilisées dans le domaine aéronautique.

Parmi les superalliages à base nickel connus, on peut notamment citer l'alliage de dénomination commerciale AM-1 correspondant à la composition décrite dans le document US 4,639,280. Les documents EP1652964A1, EP2963135A1 et US2015/377037A1 concernent d'autres matériaux de l'état de la technique. EP1652964A1 présente avec le matériau René N5 l'état de la technique le plus proche, avec une teneur massique en carbone comprise entre 300 et 700 ppm.

Il est souhaitable d'optimiser la résistance de ces alliages à l'oxydation.

### Exposé de l'invention

A ce titre, il est du mérite des inventeurs d'être parvenu à optimiser la composition d'une pièce de turbomachine afin d'obtenir des propriétés de résistances à l'oxydation améliorées. Pour cela, les inventeurs proposent une pièce de turbomachine selon la revendication 1.

L'invention propose une pièce de turbomachine comprenant un alliage de composition proche de l'AM-1 mais avec un taux d'hafnium optimisé, de sorte à présenter une meilleure résistance à l'oxydation.

Les inventeurs ont constaté qu'une telle pièce présente une résistance à l'oxydation particulièrement élevée. Sans vouloir être liés par la théorie, les inventeurs considèrent que lorsque la teneur en hafnium est trop faible, peu d'oxydation de Hf se produit et l'oxyde HfO₂ ne remplit pas le rôle de structure d'ancrage de la couche d'oxyde à la surface du superalliage. De même, si la teneur en hafnium est trop faible, l'hafnium ne bloque pas suffisamment la diffusion des cations vers l'extérieur ce qui empêche la formation des couches protectrices d'oxydes tel l'α-Al₂O₃. Pour des teneurs en hafnium au-delà de 1100 ppm, on peut avoir formation d'oxydes d'hafnium HfO₂ trop volumineux et diminution de la ténacité d'interface oxyde/métal, ce qui nuit au rôle protecteur de l'oxyde.

Dans un mode de réalisation, la teneur massique en hafnium du substrat peut être comprise entre 670 ppm et 780 ppm.

Les inventeurs ont constaté que cette teneur en hafnium permettait d'obtenir une pièce avec la meilleure résistance à l'oxydation.

De plus, les inventeurs ont constaté qu'une pièce dont la teneur en hafnium est optimisée a de bonnes propriétés mécaniques, proches de celle d'une pièce en AM1, et peut donc être utilisée dans les mêmes applications de pièces moteur que l'AM1. Il est possible mettre en forme une pièce de l'invention par les procédés de mise en forme de l'art antérieur, déjà applicables à des pièces en AM1. En particulier, la teneur optimisée en hafnium proposée ne nuit pas à la faisabilité des étapes d'homogénéisation des pièces de turbomachine qui peuvent être réalisées à la fin de la mise en forme des pièces en AM1.

Dans un mode de réalisation, le superalliage peut définir une surface externe de la pièce. En d'autres termes, il n'est pas nécessaire de recouvrir la pièce d'un revêtement pour bénéficier des propriétés de résistance à l'oxydation conférées par la pièce décrite ci-dessus.

Dans un autre mode de réalisation, un revêtement en aluminure de nickel de structure β peut être présent à la surface d'un superalliage tel que décrit ci-dessus. Ainsi, dans un mode de réalisation, une pièce de turbomachine peut comprendre :
- un substrat formé par le superalliage base nickel, et
- un revêtement en aluminure de nickel de structure β présent sur le substrat.

On notera que d'une manière générale le revêtement en aluminure de nickel de structure β peut ou non être modifié par un ou plusieurs éléments, par exemple le platine, le zirconium ou l'hafnium. Ainsi, à titre de revêtement en aluminure de nickel de structure β convenant pour l'invention on peut notamment citer le NiAl de structure β, le NiPtAl de structure β, le NiAlZr de structure β et le NiAlHf de structure β.

Dans un mode de réalisation, le revêtement en aluminure de nickel de structure β est un revêtement de NiAl de structure β ou un revêtement de NiPtAl de structure β.

Le revêtement en aluminure de nickel de structure β peut être formé par une méthode connue en soi. Par exemple, l'aluminure de nickel de structure β peut être formé par dépôt physique en phase vapeur, par dépôt chimique en phase vapeur, par cémentation en caisse ou encore par voie barbotine.

Dans le mode de réalisation précédent, une pièce de turbomachine selon l'invention peut comprendre en outre une barrière thermique présente sur le revêtement en aluminure de nickel de structure β.

Une telle barrière thermique est connue en soi, et permet de protéger la pièce de turbomachine contre les fortes températures qu'elle rencontre lors de son utilisation.

Dans un mode de réalisation, la barrière thermique peut être présente au contact du revêtement en aluminure de nickel de structure β.

Dans un mode de réalisation, le superalliage est monocristallin. Un superalliage monocristallin permet une migration plus rapide et en plus grande quantité de l'hafnium vers la surface puisque l'hafnium n'est pas piégé par le carbone généralement introduit pour stabiliser les joints de grains d'un alliage polycristallin. Ceci, améliore davantage encore la protection conférée par l'hafnium et donc la résistance à l'oxydation de la pièce.

Dans un mode de réalisation, la pièce de turbomachine peut être une aube de turbomachine, un distributeur de turbomachine, un anneau de turbine de turbomachine, ou une chambre de combustion de turbomachine. Le distributeur peut être un distributeur haute ou basse pression.

Dans un mode de réalisation préféré, la pièce de turbomachine peut être une aube de turbomachine, ou un distributeur haute pression de turbomachine.

Selon un autre de ses aspects, l'invention concerne encore une turbomachine comprenant une pièce telle que décrite ci-dessus.

### Brève description des figures

[Fig. 1] La figure 1 représente, de manière schématique et partielle, une vue en section d'une pièce de turbomachine selon un mode de réalisation de l'invention.
[Fig. 2] La figure 2 représente, de manière schématique et partielle, une vue en section d'une pièce de turbomachine selon un autre mode de réalisation de l'invention.
[Fig. 3] La figure 3 est un résultat d'essais comparatifs montrant les différences en termes de résistance à l'oxydation entre des pièces selon l'invention et des pièces hors invention.

### Description détaillée

La description va maintenant être faite au moyen de figures destinées à mieux comprendre l'invention mais ne devant aucunement être interprétées de manière limitative.

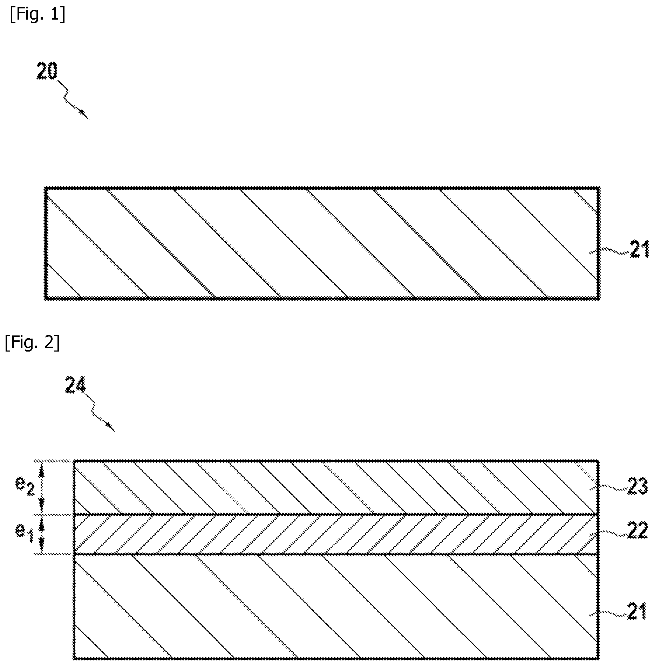

La figure 1 représente un premier mode de réalisation de l'invention, dans lequel une pièce de turbomachine 20 est réalisée uniquement en un superalliage 21 sans qu'il ne lui soit appliqué de revêtement. Dans ce mode de réalisation, le superalliage forme la partie extérieure de la pièce.

Sur la figure 2, illustrant un autre mode de réalisation particulier de l'invention, une pièce de turbomachine 24 est représentée de manière schématique composée d'un substrat en superalliage 21 et d'un revêtement 22 en aluminure de nickel de structure β qui recouvre le substrat en superalliage 21 sous-jacent.

Dans le mode de réalisation représenté, la pièce de turbomachine 24 comprend en outre une barrière thermique 23 au contact du revêtement 22 en aluminure de nickel de structure β. La barrière thermique 23 peut définir la surface externe de la pièce 20.

Dans un mode de réalisation, le revêtement 22 peut avoir une épaisseur e₁ comprise entre 40 µm et 90 µm.

De même, la barrière thermique 23 peut avoir une épaisseur e₂ comprise entre 50 µm et 300 µm.

Dans un mode de réalisation, la barrière thermique peut être choisie parmi une zircone partiellement stabilisée à l'yttrine ou un ou plusieurs autre(s) oxyde(s) de terre rare, une zircone dopée au dysprosium, du zirconate de gadolinium, une pérovskite.

Dans un mode de réalisation alternatif, la barrière thermique 23 peut être absente. Auquel cas, le revêtement 22 en aluminure de nickel de structure β peut définir la surface externe de la pièce.

### Exemple

Plusieurs échantillons d'AM-1 ont été enrichis avec une teneur massique d'hafnium allant de 340 ppm à 8000 ppm. On réalise ainsi des échantillons selon l'invention, lorsque le taux d'hafnium est compris entre 500 ppm et 1100 ppm et d'autres hors invention.

Les échantillons varient uniquement par leurs teneurs massiques en hafnium.

La teneur en hafnium des échantillons ainsi préparés est mesurée par spectrométrie de masse. Chacun des échantillons est ensuite soumis à des cycles d'oxydation, et la variation de masse de chaque échantillon est mesurée trois fois par semaine pendant les 200 premiers cycles, puis deux fois par semaine au-delà.

Les échantillons testés dans cet exemple ne sont pas revêtus. En d'autres termes, la face de l'échantillon qui subit les cycles d'oxydation est en superalliage.

Un cycle d'oxydation correspond à une chauffe très rapide jusqu'à la température d'oxydation (1150°C ± 5 °C), un maintien à 1150°C sous pression atmosphérique d'air pendant 60 minutes et enfin un refroidissement forcé avec de l'air sec pendant 15 minutes de manière à s'assurer que la température de la pièce est inférieure à 150°C ± 3°C. L'essai est stoppé lorsqu'il est observé une perte de masse spécifique de 20 mg/cm².

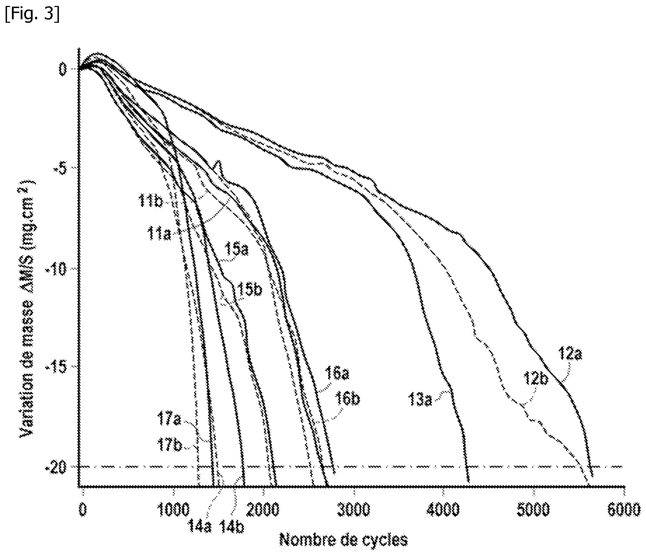

La figure 3 illustre les résultats obtenus pour chaque échantillon. Les teneurs massiques en hafnium des échantillons représentés sur la figure 3 sont pour les courbes 11a et 11b de 340 ppm, les courbes 12a et 12b de 670 ppm, la courbe 13a de 780 ppm, les courbes 16a et 16b de 1300 ppm, les courbes 15a et 15b de 2100 ppm, les courbes 14a et 14b de 4700 ppm et les courbes 17a et 17b de 8000 ppm.

Il n'y a pas de différence de composition des échantillons dont les résultats sont représentés avec un numéro suivi de la lettre a et la composition de l'échantillon dont les résultats sont représentés avec le même numéro suivi de la lettre b.

Il peut être observé sur la figure 3 que les échantillons présentant une teneur massique en hafnium comprise entre 500 ppm et 1100 ppm (12a, 12b et 13a) sont également ceux pour lesquels la perte de masse est la moins importante. Cette teneur en hafnium optimisée permet donc une meilleure résistance à l'oxydation.

L'expression « compris(e) entre ... et ... » doit se comprendre comme incluant les bornes.

## Revendications

1. Pièce (20) de turbomachine comprenant un superalliage base nickel (21) comprenant en teneur massique 5,0 % à 8,0 % de cobalt, 6,5 % à 10 % de chrome, 0,5 % à 2,5 % de molybdène, 5,0 % à 9,0 % de tungstène, 6,0 % à 9,0 % de tantale, 4,5 % à 5,8 % d'aluminium, de l'hafnium en une teneur massique comprise entre 500 ppm et 1100 ppm, et comprenant du niobium en une teneur massique comprise entre 0% et 1,5 %, et l'un au moins du carbone, du zirconium et du bore chacun en une teneur massique comprise entre 0 ppm et 100 ppm, le complément étant composé par du nickel et des impuretés inévitables.

2. Pièce (20) de turbomachine selon la revendication 1, dans laquelle la teneur massique en hafnium du superalliage (21) est comprise entre 670 ppm et 780 ppm.

3. Pièce (20) de turbomachine selon l'une des revendications 1 ou 2, dans lequel le superalliage (21) définit une surface externe de la pièce.

4. Pièce de turbomachine (24) selon l'une des revendications 1 ou 2, comprenant :
- un substrat formé par le superalliage base nickel (21), et
- un revêtement (22) en aluminure de nickel de structure β présent sur le substrat.

5. Pièce (24) de turbomachine selon la revendication 4, dans laquelle le revêtement (22) en aluminure de nickel de structure β est un revêtement de NiAl de structure β ou un revêtement de NiPtAl de structure β.

6. Pièce (24) de turbomachine selon la revendication 4 ou 5, dans laquelle une barrière thermique (23) est présente sur le revêtement (22) en aluminure de nickel de structure β.

7. Pièce (20) de turbomachine selon l'une quelconque des revendications 1 à 6, dans laquelle le superalliage (21) est monocristallin.

8. Pièce (20) de turbomachine selon l'une quelconque des revendications 1 à 7, dans laquelle ladite pièce est une aube de turbomachine, un distributeur de turbomachine, un anneau de turbomachine, ou une chambre de combustion de turbomachine.

9. Turbomachine comprenant une pièce (20) selon l'une quelconque des revendications 1 à 8.

## Patentansprüche

1. Turbomaschinenteil (20), umfassend eine Superlegierung auf Nickelbasis (21), umfassend in Massengehalt 5,0 % bis 8,0 % Kobalt, 6,5 % bis 10 % Chrom, 0,5 % bis 2,5 % Molybdän, 5,0 % bis 9,0 % Wolfram, 6,0 % bis 9,0 % Tantal, 4,5 % bis 5,8 % Aluminium, Hafnium in einem Massengehalt, der zwischen 500 ppm und 1100 ppm umfasst ist, und umfassend Niobium in einem Massengehalt, der zwischen 0 % und 1,5 % umfasst ist, und mindestens eines von Kohlenstoff, Zirkonium und Bor jeweils in einem Massengehalt, der zwischen 0 ppm und 100 ppm umfasst ist, wobei der Rest aus Nickel und unvermeidbaren Verunreinigungen besteht.

2. Turbomaschinenteil (20) nach Anspruch 1, wobei der Massengehalt an Hafnium der Superlegierung (21) zwischen 670 ppm und 780 ppm umfasst ist.

3. Turbomaschinenteil (20) nach Anspruch 1 oder 2, wobei die Superlegierung (21) eine Oberfläche außerhalb des Teils definiert.

4. Turbomaschinenteil (24) nach Anspruch 1 oder 2, umfassend:
- ein Substrat, das durch die Superlegierung auf Nickelbasis (21) gebildet ist, und
- eine Beschichtung (22) aus Nickelaluminid der Struktur β, die auf dem Substrat vorhanden ist.

5. Turbomaschinenteil (24) nach Anspruch 4, wobei die Beschichtung (22) aus Nickelaluminid der Struktur β eine Beschichtung aus NiAl der Struktur β oder eine Beschichtung aus NiPtAl der Struktur β ist.

6. Turbomaschinenteil (24) nach Anspruch 4 oder 5, wobei eine Wärmebarriere (23) auf der Beschichtung (22) aus Nickelaluminid der Struktur β vorhanden ist.

7. Turbomaschinenteil (20) nach einem der Ansprüche 1 bis 6, wobei die Superlegierung (21) monokristallin ist.

8. Turbomaschinenteil (20) nach einem der Ansprüche 1 bis 7, wobei das Teil eine Turbomaschinenschaufel, ein Turbomaschinenverteiler, ein Turbomaschinenring oder eine Turbomaschinenbrennkammer ist.

9. Turbomaschine, umfassend ein Teil (20) nach einem der Ansprüche 1 bis 8.

## Claims

1. A turbomachine part (20) comprising a nickel-based superalloy (21) comprising, in mass content, 5.0% to 8.0% cobalt, 6.5% to 10% chromium, 0.5% to 2.5% molybdenum, 5.0% to 9.0% tungsten, 6.0% to 9.0% tantalum, 4.5% to 5.8% aluminum, hafnium in a mass content between 500 ppm and 1100 ppm, and comprising niobium in a mass content comprised between 0% and 1.5%, and at least one of carbon, zirconium and boron each in a mass content comprised between 0 ppm and 100 ppm, the remainder being composed of nickel and unavoidable impurities.

2. The turbomachine part (20) according to claim 1, wherein the hafnium mass content in the superalloy (21) is between 670 ppm and 780 ppm.

3. The turbomachine part (20) according to claim 1 or 2, wherein the superalloy (21) defines an outer surface of the part.

4. The turbomachine part (24) according to claim 1 or 2, comprising:
- a substrate formed by the nickel based superalloy (21), and
- a β-structured nickel aluminide coating (22) present on the substrate.

5. The turbomachine part (24) according to claim 4, wherein the β-structured nickel aluminide coating (22) is a β-structured NiAl coating or β-structured NiPtAl coating.

6. The turbomachine part (24) according to claim 4 or 5, wherein a thermal barrier (23) is present on the β-structured nickel aluminide coating (22).

7. The turbomachine part (20) according to any one of claims 1 to 6, wherein the superalloy (21) is monocrystalline.

8. The turbomachine part (20) according to any one of claims 1 to 7, wherein said part is a turbomachine vane, a turbomachine distributor, a turbomachine turbine ring, or a turbomachine combustion chamber.

9. A turbomachine comprising a part (20) according to any one of claims 1 to 8.
